# EUROPEAN PATENT APPLICATION

(11) **EP 4 322 368 A1**
(43) Date of publication of application: **14.02.2024**
(21) Application number: 22876679.6
(22) Date of filing: 24.08.2022
(51) Int. Cl.: H02J 7/00, G01R 31/382, G01R 19/165, H01M 10/44, G06F 1/26

(54) **BATTERY PACK AND CHARGING CONTROL METHOD THEREOF**

(30) Priority: 01.10.2021 KR 20210130888
(71) Applicant: Samsung Electronics Co., Ltd., Suwon-si, Gyeonggi-do 16677 (KR)
(72) Inventor: BAE, Chanjung, Suwon-si, Gyeonggi-do 16677 (KR); LEE, Kisun, Suwon-si, Gyeonggi-do 16677 (KR)
(74) Representative: Appleyard Lees IP LLP
(86) International application number: PCT/KR2022/012645
(87) International publication number: WO 2023/054904

(57) **Abstract**

An example may include a battery cell and a controller configured to control charging of the battery cell, using a charging switch. The controller may be configured to adjust a charging current supplied to the battery cell by controlling the charging switch to prevent a voltage of a load from being less than a reference voltage when a voltage of the battery cell is equal to or less than the reference voltage while power is being supplied to the battery pack and the load connected to the battery pack.

## Description

### BACKGROUND

### 1. Field

The disclosure relates to a battery pack and technology for control of the same.

### 2. Description of Related Art

In general, electronic devices may include a charging system to charge a battery. The charging system, for example, prevents (or reduces) an abrupt change in a charging voltage (e.g., overvoltage or overcurrent), converts a charging voltage (e.g., 5 V) into a voltage suitable for charging a battery (e.g., 3 V to 4.4 V), and prevents (or reduces a possibility of) a battery from being overcharged or overdischarged. For example, a battery charging system may be configured to include a charger integrated circuit (IC), a limiter, and a battery protection IC.

### SUMMARY

Switches included in a charger integrated circuit (IC), a limiter, and a battery protection IC in the path of supplying power to a battery may increase direct current resistance, reduce charging efficiency, and raise the cost of configuring a circuit. In addition, a plurality of components may deteriorate a degree of freedom in the arrangement of components in an electronic device including a battery.

Embodiments of the disclosure may provide a battery pack and controlling method thereof that integrate the functions of a controller inside the battery pack to simplify a circuit configuration.

According to various embodiments a battery pack may include a battery cell and a controller for controlling the charging of the battery cell, using a charging switch, wherein the controller is configured to adjust a charging current supplied to the battery cell by controlling the charging switch to prevent a voltage of a load from being less than a reference voltage when a voltage of the battery cell is equal to or less than the reference voltage while power is being supplied to the battery pack and the load connected to the battery back.

According to various embodiments, a method of controlling the charging of a battery pack may include adjusting a charging current by controlling a charging switch of the battery pack and adjusting a discharge current by controlling a discharge switch of the battery pack, wherein adjusting the charging current may include adjusting the charging current supplied to a battery cell by controlling the charging switch to prevent a voltage of a load from being less than a reference voltage when a voltage of the battery cell included in the battery pack is equal to or less than a voltage of the battery cell while power is being supplied to the battery pack and the load connected to the battery pack.

According to various embodiments, an electronic device may include a first printed circuit board (PCB) including a charging connector, a charging circuit connected to the charging connector, a first load connected to the charging circuit through a wiring line and a first battery pack, wherein the first battery pack may include a first battery cell and a first controller connected to the wiring line to control charging and discharging of the first battery cell, using a first charging switch, wherein the first controller may adjust a charging current supplied to the first battery cell by controlling the first charging switch to prevent a voltage of the first load from being less than a reference voltage when a voltage of the first battery cell is less than or equal to a threshold value while power is being supplied to the first load and the first battery pack through the charging circuit.

According to various embodiments, a battery pack and control method thereof may control a charging circuit and a discharge current, using a charging switch and a discharge switch in the battery pack, and perform a protection circuit function, thereby efficiently configuring circuits in an electronic device.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram illustrating an example electronic device in a network environment according to various embodiments;
FIG. 2A is a block diagram illustrating an electronic device including a battery pack according to a comparative example;
FIG. 2B is a block diagram illustrating an example electronic device including a battery pack according to various embodiments;
FIG. 3 is a diagram illustrating an example controller of a battery pack according to various embodiments;
FIG. 4 is a diagram illustrating a battery state diagram of an example battery pack according to various embodiments;
FIGS. 5A, 5B, and 5C are diagrams illustrating an example electronic device including a battery pack according to various embodiments;
FIG. 6A is a diagram illustrating an electronic device including a battery pack according to a comparative example;
FIG. 6B is a diagram illustrating an example electronic device including a battery pack according to various embodiments;
FIG. 7A is a diagram illustrating an electronic device including a battery pack according to a comparative example;
FIG. 7B is a diagram illustrating an example electronic device including a battery pack according to various embodiments;
FIG. 8 is a diagram illustrating an example electronic device including a battery pack according to various embodiments; and
FIG. 9 is a flowchart illustrating an example method of controlling charging of a battery pack, according to various embodiments.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

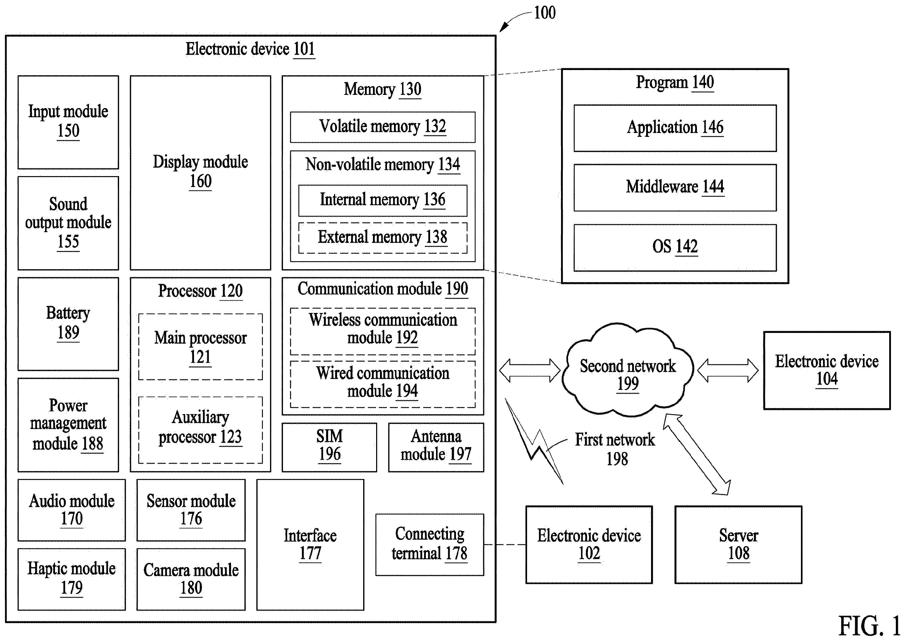

FIG. 1 is a block diagram illustrating an example electronic device 101 in a network environment 100 according to various embodiments. Referring to FIG. 1, the electronic device 101 in the network environment 100 may communicate with an electronic device 102 via a first network 198 (e.g., a short-range wireless communication network), or communicate with at least one of an electronic device 104 and a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a motor 187, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added to the electronic device 101. In various embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computations. According to an embodiment, as at least a part of data processing or computations, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specifically for artificial intelligence model processing. An artificial intelligence model may be generated by machine learning. The machine learning may be performed by, for example, the electronic device 101, in which artificial intelligence is performed, or performed via a separate server (e.g., the server 108). Learning algorithms may include, but are not limited to, for example, supervised learning, unsupervised learning, semi-supervised learning, or reinforcement learning. The artificial intelligence (AI) model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control its corresponding one of the display, the hologram device, and the projector. According to an embodiment, the display module 160 may include a touch sensor adapted to detect a touch, or a pressure sensor adapted to measure the intensity of force of the touch.

The audio module 170 may convert sound into an electric signal or vice versa. According to an embodiment, the audio module 170 may obtain the sound via the input module 150 or output the sound via the sound output module 155 or an external electronic device (e.g., the electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may physically connect to an external electronic device (e.g., the electronic device 102). According to an embodiment, the connecting terminal 178 may include, for example, an HDMI connector, a USB connector, an SD card connector, or an audio connector (e.g., a headphones connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, and flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device, for example, the electronic device 104, via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., an antenna array). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to various embodiments, the antenna module 197 may form a mmWave antenna module. According to an embodiment, the mmWave antenna module may include a PCB, an RFIC on a first surface (e.g., the bottom surface) of the PCB, or adjacent to the first surface of the PCB and capable of supporting a designated high-frequency band (e.g., a mmWave band), and a plurality of antennas (e.g., array antennas) disposed on a second surface (e.g., the top or a side surface) of the PCB, or adjacent to the second surface of the PCB and capable of transmitting or receiving signals of the designated high-frequency band.

At least some of the above-described components may be coupled mutually and exchange signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device (e.g., the electronic device 104) via the server 108 coupled with the second network 199. Each of the external electronic devices (e.g., the electronic device 102 or 104) may be a device of the same type as or a different type from the electronic device 101. According to an embodiment, all or some of operations to be executed by the electronic device 101 may be executed by one or more external electronic devices (e.g., the electronic devices 102 and 104 and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or MEC. In an embodiment, the external electronic device (e.g., the electronic device 104) may include an Internet-of-things (IoT) device. The server 108 may be an intelligent server using machine learning and/or a neural network. According to an embodiment, the external electronic device (e.g., the electronic device 104) or the server 108 may be included in the second network 199. The electronic device 101 may be applied to intelligent services (e.g., a smart home, a smart city, a smart car, or healthcare) based on 5G communication technology or IoT-related technology.

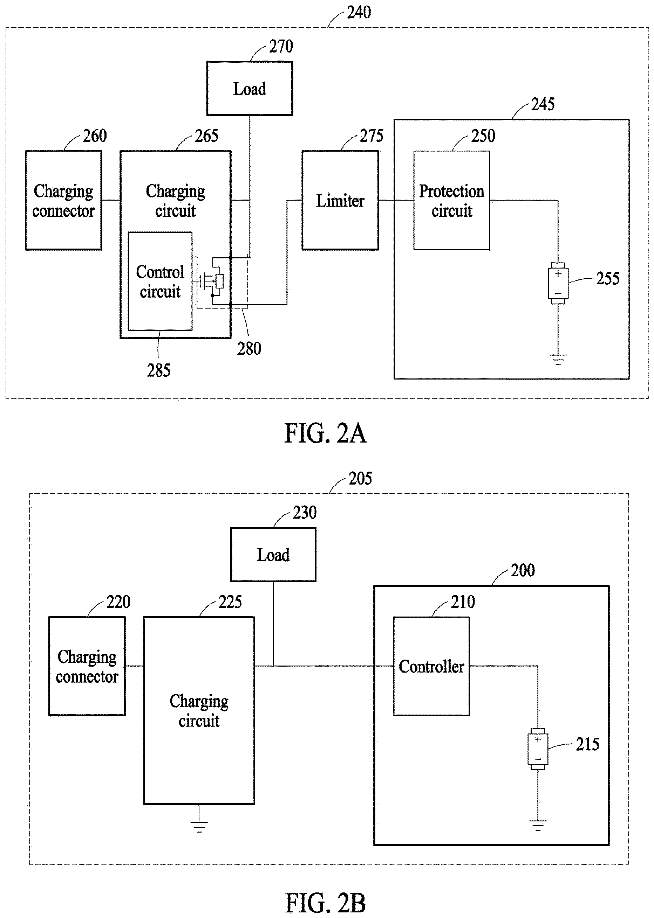

FIG. 2A is a block diagram illustrating an electronic device including a battery pack according to a comparative example, and FIG. 2B is a block diagram illustrating an example electronic device including a battery pack according to various embodiments.

Referring to FIG. 2A, an electronic device 240 including a battery pack 245, according to a comparative example, may include a charging connector 260, a charging circuit 265, a load 270, a limiter 275, and a battery pack 245. The battery pack 245 according to a comparative example may include a protection circuit 250 and a battery cell 255. The electronic device 240 according to a comparative example may include a switch 280 for controlling the charging of the battery pack 245 and a control circuit 285 for controlling the switch 280. In a comparative example, the switch 280 for charging control may be inside or outside the charging circuit 265.

The electronic device 240 according to a comparative example may control a charging current supplied to the battery pack 245, using the switch 280 for charging control. Accordingly, a circuit is required to include the switch 280 for charging control in the path of supplying power to the load 270 from the battery pack 245 of the electronic device 240 according to a comparative example, which may deteriorate the degree of freedom in the arrangement of components in the electronic device 240.

In addition, in the electronic device 240 according to a comparative example, the protection circuit 250, the limiter 275, and the charging circuit 265 may be in the path of supplying power to the load 270 from the battery pack 245 and the protection circuit 250, the limiter 275 and the charging circuit 265 may include a plurality of switches, which may form a high direct current resistance and thus reduce power efficiency.

Referring to FIG. 2B, an example electronic device 205 (e.g., the electronic device 101 in FIG. 1) according to various embodiments may include a charging connector 220, a charging circuit 225, a load 230 receiving power from the charging circuit 225, and a battery pack 200. The battery pack 200 according to various embodiments may include a battery cell 215 and a controller 210 that controls a charging current supplied to the battery cell 215. The load 230 may include various components included in the electronic device 205. Other configurations may include, for example, a processor (e.g., the processor 120 in FIG. 1), a memory (e.g., the memory 130 in FIG. 1), a communication module (e.g., the communication module 190 in FIG. 1), an antenna module (e.g., the antenna module 197 in FIG. 1), and an audio module (e.g., the audio module 170 in FIG. 1).

The battery pack 200 according to various embodiments may include the controller 210 inside the battery pack 200 and control a charging current and a discharge current to/from the battery cell 215 through the controller 210. Since the controller 210 controls, inside the battery pack 200, a charging current and a discharge current to/from the battery cell 215, the electronic device 205 including the battery pack 200, according to various embodiments, may not include a separate switch in the path of supplying power from the battery pack 200 to the load 230. This may, for example, increase a degree of freedom in the arrangement of components inside the electronic device 205, and reduced DC resistance in the path of supplying power from the battery pack 200 to the load 230 may improve power efficiency.

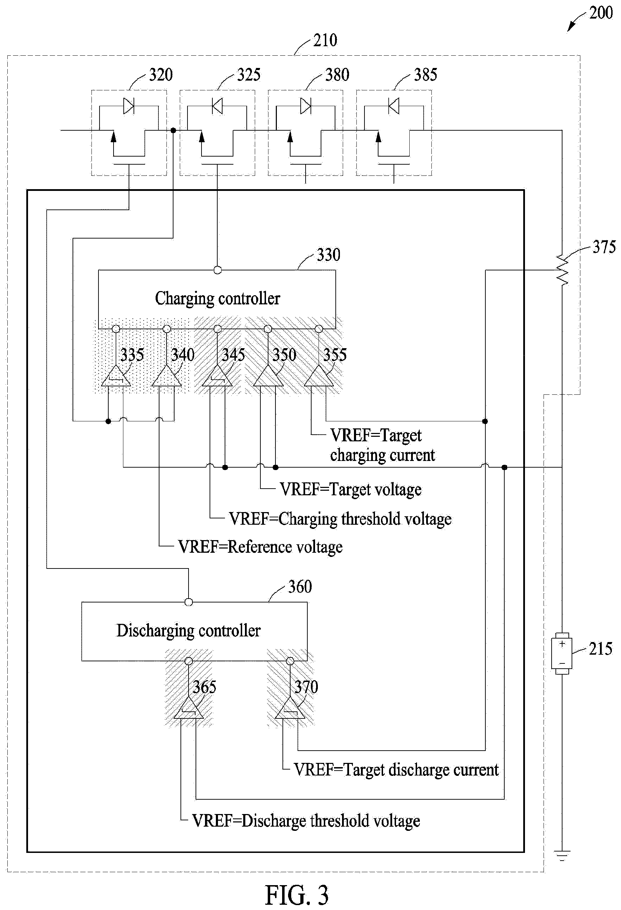

Hereinafter, an example method of controlling a battery pack, according to various embodiments, is described with reference to FIG. 3.

FIG. 3 is a diagram illustrating a controller 210 of a battery pack 200 according to various embodiments.

The controller 210 according to various embodiments may include a charging switch 325 and a discharge switch 320 and may control a charging current supplied to a battery cell 215, using the charging switch 325, and a discharge current of the battery cell 215, using the discharge switch 320. The charging switch 325 and the discharge switch 320 may, for example, be configured as a field-effect transistor (FET). In various example embodiments, the charging switch 325 may include a diode that prevents a charging current from flowing into the battery cell 215 when the charging switch 325 is turned off. In various example embodiments, the discharge switch 320 may include a diode that blocks the discharge current from flowing into a load when the discharge switch 320 is turned off. The diodes included in the charging switch 325 and the discharge switch 320 may each be or include a body diode. However, the present disclosure is not limited thereto, and the charging switch 325 and the discharge switch 320 may include other types of devices.

The controller 210 according to various embodiments may include a charging controller 330 for controlling the charging switch 325 and a discharging controller 360 for controlling the discharge switch 320. The controller 210 according to various embodiments may include comparators (e.g., first, second, third, fourth, and fifth comparators 335, 340, 345, 350, and 355) connected to the charging controller 330 and comparators (e.g., sixth and seventh comparators 365 and 370) connected to the discharging controller 360. The charging controller 330 and the discharging controller 360 may control the charging switch 325 and the discharge switch 320, respectively, based on an output of the comparators connected to each of the charging controller 330 and the discharging controller 360.

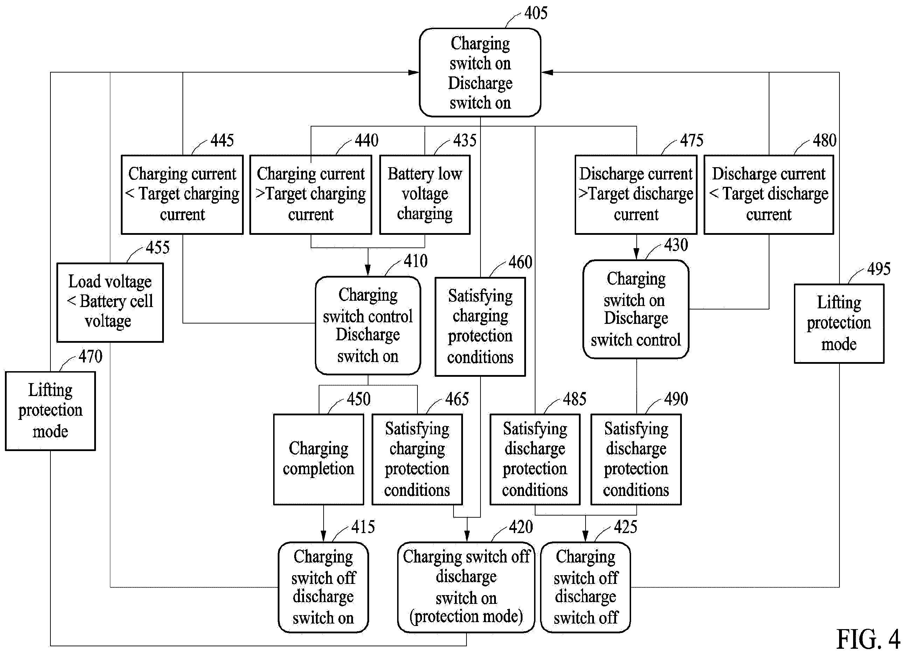

In various example embodiments, the controller 210 may include the first comparator 335 coupled to the charging controller 330. The first comparator 335 may compare a voltage of the load 230 with a voltage of the battery cell 215. Since the electronic device 205 including the battery pack 200, according to various embodiments, does not include a switch between the battery pack 200 and the load 230, the controller 210 detects a voltage at one side of the charging switch 325 to identify a voltage of the load 230. For example, as shown in FIG. 4, when the discharge switch 320 is on, the controller 210 detects a voltage between the discharge switch 320 and the charging switch 325 to identify a voltage of the load.

The charging controller 330 may turn off the charging switch 325 when the battery cell 215 is fully charged. Even when power is being supplied to the load 230 through the charging circuit 225 as the discharge switch 320 is on, when a current supplied to the load 230 increases, the battery cell 215 may be discharged by a discharge current through the diode of the charging switch 325 and the discharge switch 320.

The first comparator 335 may compare a voltage of the load 230 with a voltage of the battery cell 215. When the battery cell 215 is discharged as a voltage of the load 230 is less than that of the battery cell 215, the charging switch 325 may be turned on to recharge the battery cell 215.

In various embodiments, the controller 210 may include the second comparator 340 coupled to the charging controller 330. The second comparator 340 may compare a voltage of the load 230 with a reference voltage. The reference voltage may refer, for example, to the lowest voltage to be supplied to the load 230 in order to operate the components in the load 230. The reference voltage may be set by a processor (e.g., the processor 120 in FIG. 1) of the electronic device 205. The processor of the electronic device 205 may set the reference voltage, based on a voltage and a current of the load 230 in order to smoothly supply power to the load 230.

At a low voltage of the battery cell 215, the charging controller 330 may turn on the charging switch 325 to charge the battery cell 215. When the charging switch 325 turns on, a voltage of the load 230 may lower to a voltage of the battery cell 215. When the voltage of the battery cell 215 is lower than a reference voltage, the voltage of the load 230 may be lower than the reference voltage, which may cause malfunction of the components included in the load 230.

Even when the battery cell 215 requires charging due to its low voltage, the charging controller 330 may, for preventing malfunction of the components in the load 230, adjust a charging current by controlling the charging switch 325 so that a voltage of the load 230 may remain greater than a reference voltage when a voltage of the battery cell 215 is less than the reference voltage.

In various embodiments, the controller 210 may include the third comparator 345 coupled to the charging controller 330. The third comparator 345 may compare a voltage of the battery cell 215 with a charging threshold voltage. The charging threshold voltage may be, for example, a voltage determined to prevent the battery cell 215 from being overcharged.

The charging controller 330 may turn off the charging switch 325 when charging protection conditions are satisfied, based on the output of the third comparator 345. For example, the charging protection conditions may be deemed to be satisfied in any of the following cases: when a voltage of the battery cell 215 exceeds a charging threshold voltage, when a charging current exceeds a threshold charging current, or when a temperature of the battery cell 215 exceeds a threshold temperature. However, the present disclosure is not limited thereto, and the charging protection conditions may be set in various ways.

In various embodiments, the controller 210 may include the fourth comparator 350 coupled to the charging controller 330. The fourth comparator 350 may compare a voltage of the battery cell 215 with a target voltage. When a voltage of the battery cell 215 reaches a set target voltage, based on the output of the fourth comparator 350, the charging controller 330 may adjust a charging current to control the charging switch 325 so that a constant voltage (CV) may be controlled. For example, the charging switch 325 may include a field effect transistor (FET) and the charging controller 330 may adjust a gate voltage of the charging switch 325 to control the intensity of a current passing through the charging switch 325.

In various embodiments, the controller 210 may include the fifth comparator 355 coupled to the charging controller 330. The fifth comparator 355 may compare, with a set target charging current, a charging current sensed by a sensing resistor 375 connected to the battery cell 215.

The charging controller 330 may control the charging switch 325 to reduce a charging current when the charging current exceeds a target charging current, based on the output of the fifth comparator 355. The charging controller 330 may turn on the charging switch 325 when the charging current is less than the target charging current.

In various embodiments, the controller 210 may include the sixth comparator 365 coupled to the discharging controller 360. The sixth comparator 365 may compare a voltage of the battery cell 215 with a discharge threshold voltage. The discharge threshold voltage may be a voltage determined to prevent the battery cell 215 from being overdischarged.

The discharging controller 360 may turn off the discharge switch 320 when discharge protection conditions are satisfied, based on the output of the sixth comparator 365. For example, the discharge protection conditions are deemed to be satisfied in any one of the following cases: when a voltage of the battery cell 215 is less than a discharge threshold voltage, when a discharge current exceeds a threshold discharge current, or when a temperature of the battery cell 215 exceeds a threshold temperature. However, the present disclosure is not limited thereto, and the discharge protection conditions may be set in various ways.

In various example embodiments, the controller 210 may include the seventh comparator 370 coupled to the discharging controller 360. The seventh comparator 370 may compare a sensed discharge current with a set target discharge current by using a sensing resistor connected to the battery cell 215.

The discharging controller 360 may reduce a discharge current by controlling the discharge switch 320 when a discharge current exceeds a target discharge current, based on the output of the seventh comparator 370. The discharging controller 360 may turn on the discharge switch 320 when a discharge current is less than a target discharge current.

In various example embodiments, the controller 210 may further include at least one discharge switch 380 and at least one charging switch 385.

The controller 210 may turn off the at least one charging switch 385 when the charging protection conditions are satisfied, based on the output of the third comparator 345. The controller 210 may turn off the at least one discharge switch 380 when the discharge protection conditions are satisfied, based on the output of the sixth comparator 365. In various embodiments, the at least one discharge switch 380 and at least one charging switch 385 may not be included in the controller 210.

The controller 210 according to various embodiments may control a charging current and a discharge current, using the charging switch 325 and the discharge switch 320 inside the battery pack 200, which may simplify circuit configurations among the battery pack 200, the charging circuit 225, and the load 230 and reduce direct-current resistance to efficiently transmit power.

Hereinafter, an example operation of a controller 210 is described using a state diagram with reference to FIG. 4.

FIG. 4 is a diagram illustrating a battery state diagram of an example battery pack, according to various embodiments.

Referring to FIG. 4, a controller may control at least one of a charging switch (e.g., the charging switch 325 in FIG. 3) and a discharge switch (e.g., the discharge switch 320 in FIG. 3) to be in one of states 405, 410, 415, 420, 425, and 430.

When a battery cell 215 is discharged, a controller 210 may, in state 405, turn on both a charging switch 325 and a discharge switch 320 for charging the battery cell 215.

In case 435, where a voltage of the battery cell 215 is less than a reference voltage, when both the charging switch 325 and the discharge switch 320 turn on, a voltage of the load 230 reduces to the voltage of the battery cell 215, which may drop the voltage of the load 230 to a level less than the reference voltage and prevent the components of the load 230 from operating properly. In order to prevent this, in case 435, where a voltage of the battery cell 215 is less than a reference voltage, the controller 210 may, in state 410, reduce a charging current by controlling the charging switch 325 so that a voltage of the load 230 remains equal to or greater than the reference voltage.

Alternatively, in case 440 where a charging current exceeds a target charging current in the state 405, the controller 210 may, in state 410, control the charging switch 325 so that the charging current remains equal to or less than the target charging current.

In case 445, where a charging current is less than a target charging current in state 410, the controller 210 may, in state 405, turn on the charging switch 325 again to increase the charging current.

In case 450, where the charging of the battery cell 215 has been completed in state 405 or state 410, the controller 210 may, in state 415, turn off the charging switch 325 to discontinue the supply of a charging current to the battery cell 215. In state 415, the discharge switch 320 may remain on.

In case 455, where a current of the battery cell 215 discharges to the load 230 through the diode of the charging switch 325 and the discharge switch 320 since a voltage of the load 230 is less than a voltage of the battery cell 215 in state 415, the controller 210 may, in state 405, turn on the charging switch to recharge battery cell 215.

In case 460, where charging protection conditions are satisfied in state 405, or in case 465, where the charging protection conditions are satisfied in state 410, the controller 210 may, in state 420, turn off the charging switch 325 to protect the battery cell 215.

In case 470, where the charging protection conditions are no longer satisfied in state 420, the controller 210 may turn on the charging switch 325 again in state 405.

In case 475, where a discharge current exceeds a target discharge current in state 405, the controller 210 may, in state 430, control the discharge switch 320 so that the discharge current remains less than the target discharge current.

In case 480, where a discharge current is less than a target discharge current in state 430, the controller 210 may turn on the discharge switch 320 again to increase the discharge current.

In case 485, where discharge protection conditions are satisfied in state 405, or in case 490, where the discharge protection conditions are satisfied in state 430, the controller 210 may turn off the discharge switch 320 in state 425 to protect the battery cell 215.

In case 495, where the discharge protection conditions are no longer met in state 425, the controller 210 may turn on the discharge switch 320 again in state 405.

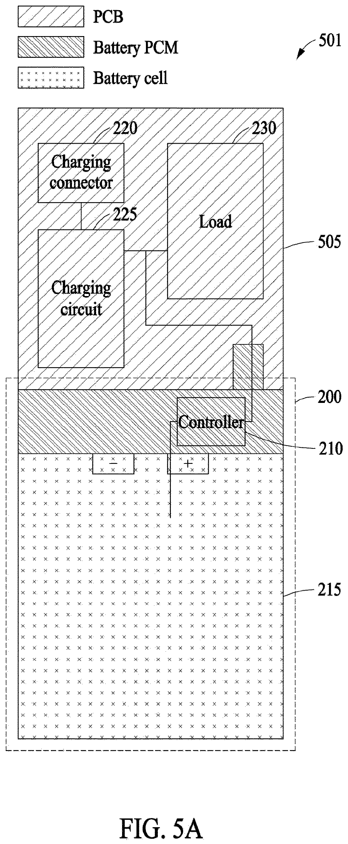

Hereinafter, various embodiments of an electronic device including a battery pack is described with reference to FIGS. 5A, 5B, 5C, 6A, 6B, 7A, 7B, and 8.

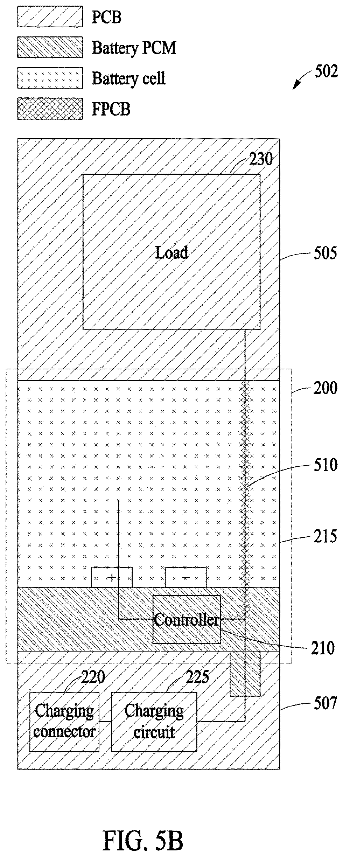

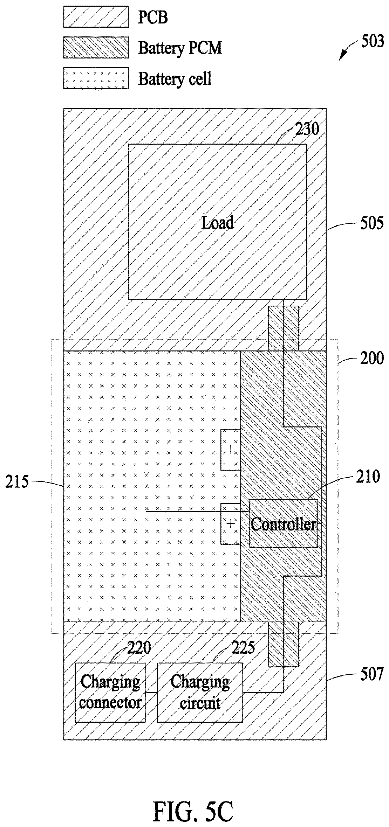

FIGS. 5A, 5B, and 5C are diagrams illustrating an example electronic device including a battery pack according to various embodiments.

In FIG. 5A, an electronic device 501 (e.g., the electronic device 101 in FIG. 1) may include a first PCB 505 including a charging connector 220, a charging circuit 225, a load 230, and a battery pack 200. In FIGS. 5B and 5C, electronic devices 502 and 503 (e.g., the electronic device 101 in FIG. 1) may include first PCBs 505 and 507, and a battery pack 200, wherein the first PCBs 505 and 507 may include at least one of a charging connector 220, a charging circuit 225 and a load 230.

The battery pack 200 may include a protection circuit (PCM) and a battery cell 215, wherein the PCM includes a controller 210. In FIG. 5B, the electronic device 502 may further include a flexible printed circuit board (FPCB) 510 for connecting a controller 210 of the battery pack to the first PCB 505.

In FIGS. 5A to 5C, the electronic devices 501, 502, and 503 include the battery pack 200, according to various embodiments, thereby supplying power output by the battery pack 200 to the charging circuit 225 or directly to the load 230 without using a switch 280 for charging the battery pack 200, as shown in FIG. 2A.

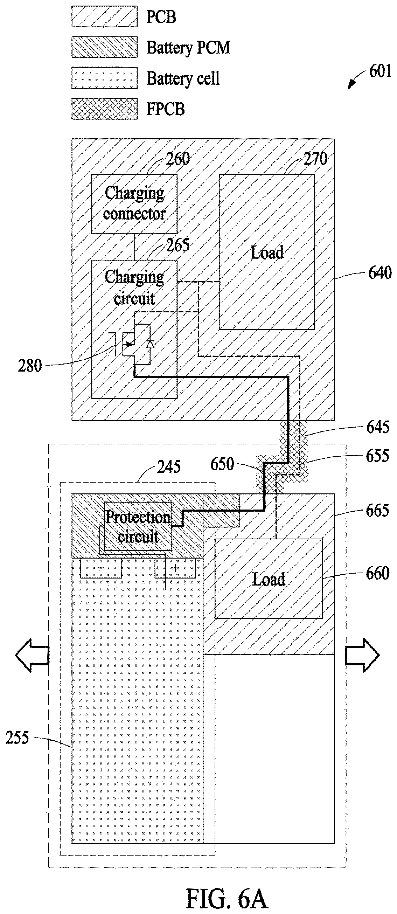

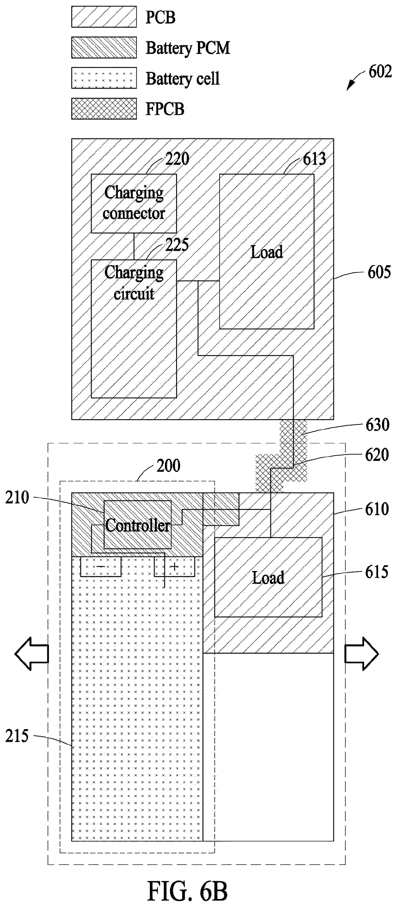

FIG. 6A is a diagram illustrating an electronic device including a battery pack according to a comparative example, and FIG. 6B is a diagram illustrating an example electronic device including a battery pack according to various embodiments.

Referring to FIG. 6A, an electronic device 601 including a battery pack 245, according to a comparative example, may include a first PCB 640 including a charging connector 260, a charging circuit 265, and a first load 270, a second PCB 665 including a second load 660, an FPCB 645 connecting the first PCB 640 to the second PCB 665, and a battery pack 245. The battery pack 245 and the second PCB 665 may be configured to be movable in connection with the first PCB 640 through the FPCB 645.

In the comparative example in FIG. 6A, as the charging and discharge of the battery cell 255 is controlled via a switch 280 for charging inside the charging circuit 265, the battery pack 245 requires coupling to the switch 280 for charging in the first PCB 640 and the power output by the battery pack 245 may not be directly supplied to the load. In addition, as the FPCB 645 needs to include a first wiring line 650 connecting the battery pack 245 to the switch 280 for charging the battery pack 245, and a second wiring line 655 connecting the charging circuit 265 to the loads 270 and 660, the thickness of the FPCB 645 increases, which may deteriorate the degree of freedom in the arrangement of components in the electronic device 601.

Referring to FIG. 6B, the example electronic device 602 (e.g., the electronic device 101 in FIG. 1) may include a first PCB 605 including a charging connector 220, a charging circuit 225 and a first load 613, a second PCB 610 including a second load 615, an FPCB 630 connecting the first PCB 605 to the second PCB 610, and a battery pack 200. The battery pack 200 may include a battery cell 215 and a controller 210. The electronic device 602 according to various embodiments may include a wiring line 620 connecting the charging circuit 225 to the first and second loads 613 and 615. The wiring line 620 may be connected to the controller 210.

In FIG. 6B, the electronic device 602 may control a charging current and a discharge current of the battery cell 215, using the controller 210 in the battery pack 200. The FPCB 630 may include only one wiring line 620 without having to use another wiring line for controlling the charging and discharge of the battery cell 215. The battery pack 200 may directly couple to the first load 613 and the second load 615 through the wiring line 620 to supply power.

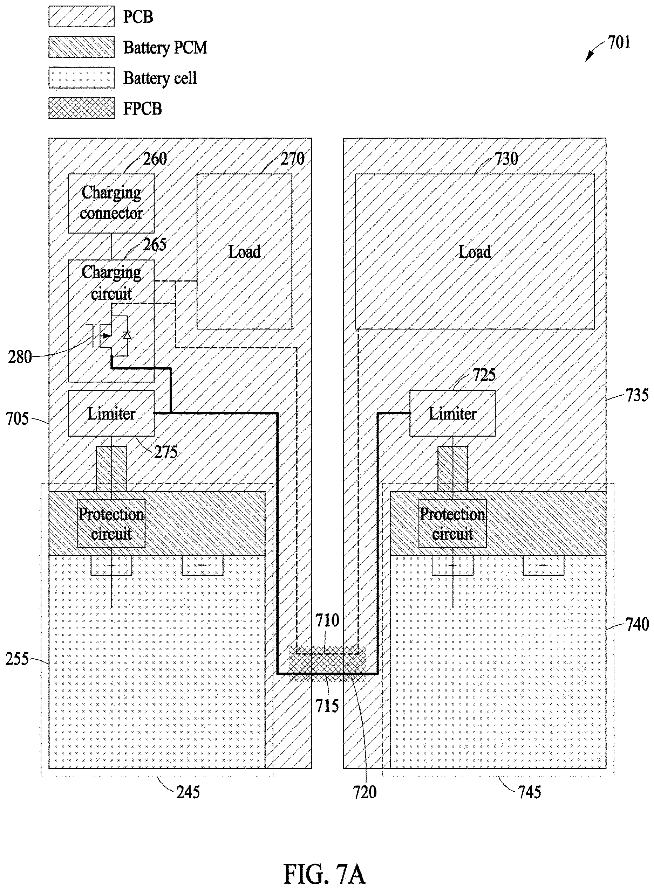

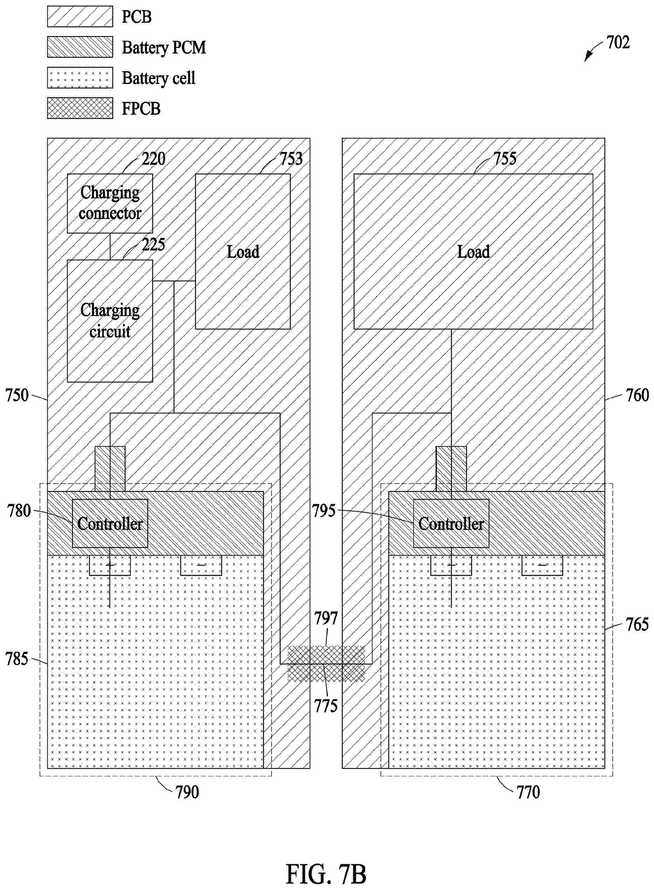

FIG. 7A is a diagram illustrating an electronic device including a battery pack according to a comparative example, and FIG. 7B is a diagram illustrating an example electronic device including a battery pack according to various embodiments.

In a comparative example in FIG. 7A, an electronic device 701 may include a first PCB 705 including a charging connector 260, a charging circuit 265, a first load 270, and a first limiter 275, a second PCB 735 including a second load 730 and a second limiter 725, an FPCB 720 connecting the first PCB 705 to the second PCB 735, a first battery pack 245, and a second battery pack 745.

In a comparative example in FIG. 7A, since the charging and discharging of the battery cells 255 and 740 are controlled by a switch 280 for charging the battery pack 245 and the battery pack 745 in the charging circuit 265, the first and second limiters 275 and 725 are required to be connected to the switch 280, on the first PCB 705, for charging the battery pack 245 and the battery pack 745 and the power output by the first and second battery packs 245 and 745 may not be directly supplied to the first and second loads 270 and 730. In addition, the thickness of the FPCB 720 increases as the FPCB 720 needs to include a first wiring line 715 connecting the first and second limiters 275 and 725 to the switch 280 for charging the battery pack 245 and the battery pack 745, and a second wiring line 710 connecting the charging circuit 265 to the first and second loads 270 and 730, which may deteriorate the degree of freedom in the arrangement of components in the electronic device.

In FIG. 7B, an electronic device 702 (e.g., the electronic device 101 in FIG. 1) may include a first PCB 750 including a charging connector 220, a charging circuit 225, and a first load 753, a second PCB 760 including a second load 755, an FPCB 797 connecting the first PCB 750 to the second PCB 760, a first battery pack 790 (e.g., the battery pack 200 in FIG. 2B), and a second battery pack 770 (e.g., the battery pack 200 in FIG. 2B). The first battery pack 790 may include a first battery cell 785 and a first controller 780 and the second battery pack 770 may include a second battery cell 765 and a second controller 795.

In FIG. 7B, the electronic device 702 may use the first controller 780 and the second controller 795 included in the first battery pack 790 and the second battery pack 770, respectively, to control a charging current and a discharge current of the first battery cell 785 and the second battery cell 765.

The first PCB 750 may include a wiring line 775 connecting the charging circuit 225 to the first load 753. The wiring line 775 may be connected to the first controller 780. The wiring line 775 may be connected to the second load 755 and the second controller 795 through the FPCB 797.

In various embodiments, the first battery pack 790 and the second battery pack 770 may control a charging current and a discharge current, using the controller inside each battery pack, to directly supply power to the first load 753 or the second load 755 without using the charging circuit 225. For example, the first battery pack 790 may supply power to the first load 753 and the second load 755 through the wiring line 775.

The FPCB 797 may include only one wiring line 775 without a separate wiring line for controlling the charging and discharging of the second battery cell 765. Accordingly, a circuit configuration in the electronic device 702 may be simplified and a degree of freedom in the arrangement of components in the electronic device 702 may improve.

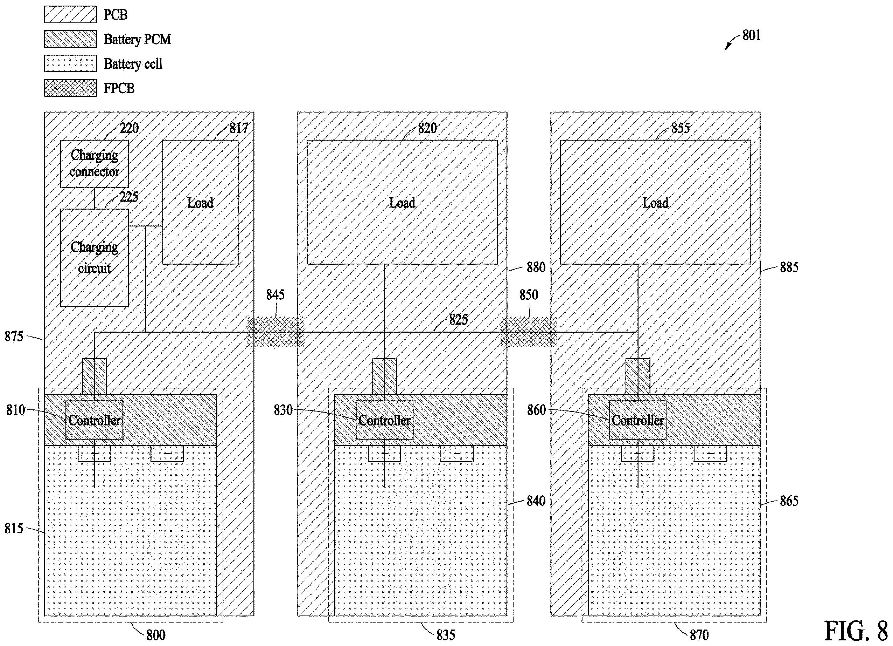

FIG. 8 is a diagram illustrating an example electronic device according to various embodiments including three battery packs connected in parallel.

Referring to FIG. 8, an electronic device 801 (e.g., the electronic device 101 in FIG. 1) may include a first PCB 875 including a charging connector 220, a charging circuit 225, and a first load 817, a second PCB 880 including a second load 820, a third PCB 885 including a third load 855, a first FPCB 845 connecting the first PCB 875 to the second PCB 880, a second FPCB 850 connecting the second PCB 880 to the third PCB 885, a first battery pack 800 (e.g., the battery pack 200 in FIG. 2B), a second battery pack 835 (e.g., the battery pack 200 in FIG. 2B), and a third battery pack 870 (e.g., the battery pack 200 in FIG. 2B).

The first battery pack 800 may include a first controller 810 and a first battery cell 815. The second battery pack 835 may include a second controller 830 and a second battery cell 840. The third battery pack 870 may include a third controller 860 and a third battery cell 865.

In FIG. 8, the electronic device 801 may use the first controller 810, the second controller 830, and the third controller 860 included in the first battery pack 800, the second battery pack 835 and the third battery pack 870, respectively, to control charging currents and discharge currents of the first battery cell 815, the second battery cell 840, and the third battery cell 865.

In FIG. 8, the first PCB 875 may include a wiring line 825 connecting the charging circuit 225 to the first load 817. The wiring line 825 may be connected to the first controller 810. The wiring line 825 may be connected to the second load 820 and the second controller 830 through the first FPCB 845. The wiring line 825 may be connected to the third load 855 and the third controller 860 through the second FPCB 850.

The first battery pack 800, the second battery pack 835, and the third battery pack 870 may use the controllers (e.g., the first controller 810, the second controller 830, and the third controller 855) inside the battery packs, respectively, to control charging currents and discharge currents, thereby directly supplying power to loads (e.g., the first load 817, the second load 820, and the third load 855) without using the charging circuit 225, For example, the first battery pack 800 may supply power to the first load 817, the second load 820, and the third load 855 through the wiring line 825.

The first FPCB 845 may include only one wiring line 825 without a separate wiring line for controlling the charging and discharging of the second battery cell 840 and the third battery cell 865. The second FPCB 850 may include only one wiring line 825 without a separate wiring line for controlling the charging and discharging of the third battery cell 865. This may simplify a circuit configuration in the electronic device 801 and improve a degree of freedom in the arrangement of the components in the electronic device 801.

In the embodiments in FIGS. 7B and 8, each controller (e.g., the first controller 780, the second controller 795, the first controller 810, the second controller 830, and the third controller 860) may operate independently, based on a voltage and a current of the battery pack connected to the controller.

Although FIGS. 7B and 8 illustrate various embodiments in which battery cells are connected in parallel, the present disclosure is not limited thereto, and a plurality of PCBs and battery packs according to various embodiments may be connected to one another. For example, battery packs may be connected to one another in series.

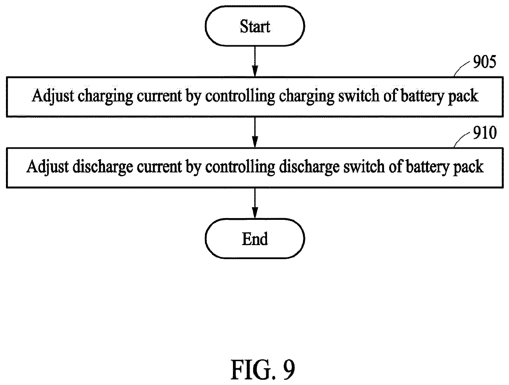

FIG. 9 is a flowchart illustrating an example method of controlling charging by a battery pack, according to various embodiments.

Referring to FIG. 9, a controller 210 of a battery pack 200 according to various embodiments controls a charging switch 325 of the battery pack 200 to adjust a charging current supplied to a battery cell 215, in operation 905.

When a voltage of the battery cell 215 is equal to or less than a reference voltage and the charging switch 325 turns on, a voltage of the load 230 connected to the battery pack 200 may drop to a voltage of the battery cell 215 and become less than the reference voltage, which may prevent the components of the load 230 from operating properly. The reference voltage may refer, for example, to the lowest voltage to be supplied to operate components included in the load 230. When a voltage of the battery cell 215 is equal to or less than a reference voltage, the controller 210 may reduce a charging current by controlling the charging switch 325 so that a voltage of the load 230 remains equal to or greater than the reference voltage. In various embodiments, a voltage of the load 230 may be sensed at one side of the charging switch 325.

When the charging of the battery cell 215 has been completed, the controller 210 may turn off the charging switch 325. When a voltage of the load 230 is lower than a voltage of the battery cell 215 after the charging of the battery cell 215 is completed, a current of the battery cell 215 may discharge to the load 230 through the body diode of the charging switch 325, and the discharge switch 320. When a voltage of the load 230 is lower than a voltage of the battery cell 215 so that a current of the battery cell 215 discharges to the load 230 through the diode of the charging switch 325 and the discharge switch 320, the controller 210 may turn on the charging switch 325 to recharge the battery cell 215.

The controller 210 may turn off the charging switch 325 when charging protection conditions are satisfied. For example, the controller 210 may turn off the charging switch 325 in any of the following cases: when a voltage of the battery cell 215 exceeds a charging threshold voltage, when a charging current exceeds a threshold charging current, or when a temperature of the battery cell 215 exceeds a threshold temperature. However, the present disclosure is not limited in this respect, and the charging protection conditions may be set in various ways.

The controller 210 may further include at least one charging switch 325 and may turn off the at least one charging switch 325 when the charging protection conditions are satisfied.

When a charging current exceeds a target charging current, the controller 210 may control the charging switch 325 to reduce the charging current. When a charging current is less than a target charging current, the controller 210 may turn on the charging switch 325 to increase the charging current.

When a voltage of the battery cell 215 reaches a target voltage, the controller 210 may reduce a charging current by controlling the charging switch 325 so that the voltage of the battery cell 215 is maintained at the level of the target voltage.

In operation 910, the controller 210 may control the discharge switch 320 of the battery pack 200 to adjust a discharge current discharged by the battery cell 215. A discharge current may be supplied to the load 230 connected to the battery cell 215.

The controller 210 may turn off the discharge switch 320 when discharge protection conditions are satisfied. For example, the controller 210 may turn off the discharge switch 320 in any of the following cases: when a voltage of the battery cell 215 is less than a discharge threshold voltage, when a discharge current exceeds a threshold discharge current, or when a temperature of the battery cell 215 exceeds a threshold temperature. However, the present disclosure is not limited in this respect, and the discharge protection conditions may be set in various ways.

The controller 210 may further include at least one discharge switch 320 and may turn off the at least one discharge switch 320 when the discharge protection conditions are satisfied.

When a discharge current exceeds a target discharge current, the controller 210 may control the discharge switch 320 to reduce the discharge current. When a discharge current is less than a target discharge current, the controller 210 may turn on the discharge switch 320 to increase the discharge current.

A battery pack 200 according to various embodiments may include a battery cell 215 and a controller 210 that controls the charging of the battery cell 215, using a charging switch 325, wherein the controller 210 may adjust a charging current supplied to the battery cell 215 by controlling the charging switch 325 to prevent a voltage of a load 230 from being less than a reference voltage when a voltage of the battery cell 215 is equal to or less than the reference voltage while power is being supplied to the battery pack 200 and the load 230 connected to the battery pack 200.

The controller 210 according to various embodiments may turn off the charging switch 325 when the charging of the battery cell 215 is completed and may turn on the charging switch 325 when a voltage of the load 230 is equal to or less than a voltage of the battery cell 215 after the charging of the battery cell is completed.

The controller 210 according to various embodiments may further include a discharge switch 320 and may control discharging of the battery cell 215, using the discharge switch 320.

The controller 210 according to various embodiments may turn off the charging switch 325 when charging protection conditions are satisfied and may turn off the discharge switch 320 when discharging protection conditions are satisfied.

The controller 210 according to various embodiments may further include at least one charging switch 325 and at least one discharge switch 320 and may turn off the at least one charging switch 325 when the charging protection conditions are satisfied and turn on the at least one discharge switch 320 when the discharge protection conditions are satisfied.

The controller 210 according to various embodiments may control the charging switch 325 to reduce a charging current when the charging current exceeds a target charging current and may control the discharge switch 320 to reduce a discharge current when the discharge current exceeds a target discharge current.

The controller 210 according to various embodiments may increase a charging current by turning on the charging switch 325 when the charging current is less than a target charging current and may increase a discharge current by turning on the discharge switch 320 when the discharge current is less than a target discharge current

When a voltage of the battery cell 215 reaches a target voltage, the controller 210 according to various embodiments may control the charging switch 325 to keep the voltage of the battery cell 215 at the target voltage, thereby reducing a charging current.

The controller 210 according to various embodiments may sense a voltage at one side of the charging switch 325 to identify a voltage of the load 230.

According to various embodiments, a method of controlling the charging of a battery pack 200 may include adjusting a charging current by controlling a charging switch 325 of the battery pack 200 and adjusting a discharge current by controlling a discharge switch 320 of the battery pack 200, wherein adjusting the charging current may include adjusting a charging current supplied to a battery cell 215 by controlling the charging switch 325 to prevent a voltage of a load 230 from being less than a reference voltage when a voltage of the battery cell 215 in the battery pack 200 is equal or less than the reference voltage while power is being supplied to the battery pack 200 and the load 230 connected to the battery pack 200.

Adjusting the charging current according to various embodiments may include turning off the charging switch 325 when the charging of the battery cell 215 is completed and turning on the charging switch 325 when a voltage of the load 230 is lower than a voltage of the battery cell 215 after the charging of the battery cell is completed.

Adjusting the charging current according to various embodiments may include turning off the charging switch 325 when charging protection conditions are satisfied and turning off the discharge switch 320 when discharging protection conditions are satisfied.

According to various embodiments, the battery pack 200 may further include at least one charging switch 325 and at least one discharge switch 320. Adjusting the charging current may include turning off the at least one charging switch 325 when the charging protection conditions are satisfied. Adjusting the discharge current may include turning off the at least one discharge switch 320 when the discharge protection conditions are satisfied.

Adjusting the charging current according to various embodiments may include reducing a charging current by controlling the charging switch 325 when the charging current exceeds a target charging current, and controlling a discharge current may include reducing the discharge current by controlling the discharge switch 320 when the discharge current exceeds a target discharge current.

Adjusting the charging current according to various embodiments may include increasing a charging current by turning on the charging switch 325 when the charging current is less than a target charging current, and controlling the discharge current may include increasing a discharge current by turning on the discharge switch 320 when the discharge current is less than a target current.

Adjusting the charging current according to various embodiments may include reducing a charging current by controlling the charging switch 325 so that a voltage of the battery cell 215 remains at a target voltage when a voltage of the battery cell 215 reaches the target voltage.

A voltage of the load 230 according to various embodiments may be sensed at one side of the charging switch 325.

An electronic device 702 according to various embodiments may include a first PCB 750 including a charging connector 220, a charging circuit 225 connected to the charging connector 220, and a first load 230 connected to the charging circuit 225 through a wiring line 775, and a first battery pack 790, wherein the first battery pack 790 may include a first battery cell 785 and a first controller 210 or 780 connected to the wiring line 775 to control charging and discharging of the first battery cell 785, using a first charging switch (e.g., the charging switch 325) and a first discharge switch (e.g., the discharge switch 320), wherein the first controller 210 or 780 may control a charging current supplied to the first battery cell 785 by controlling the first charging switch to prevent a voltage of the first load 230 from being less than a reference voltage when a voltage of the first battery cell 785 is equal to or less than a threshold value while power is being supplied to the first load 230 and the first battery pack 790 through the charging circuit 225.

The electronic device 702 according to various embodiments may further include a second PCB 760 including a second load 755, an FPCB 797 connecting the first PCB 750 to the second PCB 760, and a second battery pack 770 including a second controller 795 and a second battery cell 765 connected to the second controller 795. The wiring line 775 may couple to the second load 755 and the second controller 795 through the FPCB 797.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to various embodiments, the electronic device is not limited to those described above.

It should be understood that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "1st", "2nd", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or combinations thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-predetermined integrated circuit (ASIC).

Various embodiments as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Here, the term "non-transitory" storage medium refers, for example, to a tangible device, and may not include a signal (e.g., an electromagnetic wave), but this term does not differentiate between where data is semi-permanently stored in the storage medium and where the data is temporarily stored in the storage medium.

A method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A battery pack comprising:
a battery cell; and
a controller configured to control charging of the battery cell, using a charging switch,
wherein the controller is configured to adjust a charging current supplied to the battery cell by controlling the charging switch to prevent a voltage of a load from being less than a reference voltage when a voltage of the battery cell is equal to or less than the reference voltage while power is being supplied to the battery pack and the load.

2. The battery pack of claim 1, wherein the controller is configured to turn off the charging switch when the charging of the battery cell is completed and turn on the charging switch when a voltage of the load is less than a voltage of the battery cell after the charging of the battery cell is completed.

3. The battery pack of claim 1, wherein the controller further comprises a discharge switch and is configured to control discharging of the battery cell, using the discharge switch.

4. The battery pack of claim 3, wherein the controller is configured to:
turn off the charging switch when charging protection conditions are satisfied and turn off the discharge switch when discharge protection conditions are satisfied.

5. The battery pack of claim 4, wherein the controller further comprises at least one charging switch and at least one discharge switch, and is configured to turn off the at least one charging switch when the charging protection conditions are satisfied, and turn off the at least one discharge switch when the discharge protection conditions are satisfied.

6. The battery pack of claim 3, wherein the controller is configured to:
reduce a charging current by controlling the charging switch when the charging current exceeds a target charging current and reduce a discharge current by controlling the discharge switch when the discharge current exceeds a target discharge current.

7. The battery pack of claim 6, wherein the controller is configured to:
turn on the charging switch to increase a charging current when the charging current is less than a target charging current and turn on the discharge switch to increase a discharge current when the discharge current is less than a target discharge current.

8. The battery pack of claim 3, wherein the controller is configured to:
reduce a charging current by controlling the charging switch so that a voltage of the battery cell remains at a target voltage when the voltage of the battery cell reaches the target voltage.

9. A method of controlling charging of a battery pack, the method comprising:
adjusting a charging current by controlling a charging switch of the battery pack; and
adjusting a discharge current by controlling a discharge switch of the battery pack,
wherein the adjusting of the charging current comprises adjusting the charging current supplied to a battery cell by controlling the charging switch to prevent a voltage of a load from being less than a reference voltage when a voltage of the battery cell included in the battery pack is equal to or less than the reference voltage while power is being supplied to the battery pack and the load connected to the battery pack.

10. The method of claim 9, wherein the adjusting of the charging current comprises:
turning off the charging switch when the charging of the battery cell is completed; and
turning on the charging switch when a voltage of the load is less than a voltage of the battery cell after the charging of the battery cell is completed.

11. The method of claim 9, wherein
the adjusting of the charging current comprises turning off the charging switch when charging protection conditions are satisfied, and
the adjusting of the discharge current comprises turning off the discharge switch when discharge protection conditions are satisfied.

12. The method of claim 11, wherein
the battery pack further comprises at least one charging switch and at least one discharge switch,
the adjusting of the charging current comprises turning off the at least one charging switch when the charging protection conditions are satisfied, and
the adjusting of the discharge current comprises turning off the at least one discharge switch when the discharge protection conditions are satisfied.

13. The method of claim 9, wherein
the adjusting of the charging current comprises reducing the charging current by controlling the charging switch when the charging current exceeds a target charging current, and
the adjusting of the discharge current comprises reducing the discharge current by controlling the discharge switch when the discharge current exceeds a target discharge current.

14. The method of claim 13, wherein
the adjusting of the charging current comprises increasing the charging current by turning on the charging switch when the charging current is less than the target charging current, and
the adjusting of the discharge current comprises increasing the discharge current by turning on the discharge switch when the discharge current is less than the target discharge current.

15. The method of claim 9, wherein the adjusting of the charging current comprises reducing the charging current by controlling the charging switch so that a voltage of the battery cell remains at a target voltage when a voltage of the battery cell reaches the target voltage.
